# EUROPEAN PATENT APPLICATION

(11) **EP 4 269 957 A1**
(43) Date of publication of application: **01.11.2023**
(21) Application number: 23170216.8
(22) Date of filing: 26.04.2023
(51) Int. Cl.: G01F 15/00, G01D 4/02, G01R 22/06

(54) **A DEVICE FOR DETECTING ACCESS TO A PIT WHICH HOUSES A WATER UTILITY METER**

(30) Priority: 29.04.2022 GB 202206339
(71) Applicant: Deer Technology Limited, Port Talbot Neath Port Talbot SA12 7AX (GB)
(72) Inventor: Jackson, Garry Raymond, Port Talbot, SA12 7AX (GB); Mort, Hugh William, Port Talbot, SA12 7AX (GB)
(74) Representative: Dempster, Benjamin John Naftel

(57) **Abstract**

The invention provides a device (4) for detecting opening of an access cover (1) to a pit (2) in which a water utility meter (5) is housed. The device (4) is arranged to be attached to a water utility meter (5). The device (4) includes a light sensor (16) to sense ambient light.

## Description

This invention relates to a device.

A water utility meter is mounted on a pipe in a pit in the ground. The meter will be accessed by lifting an access cover.

If an access cover is lifted and left open, it can constitute a significant risk to public safety.

It is also a problem, that utility meters can be tampered with.

A known utility meter reading device is disclosed in WO2019/81877, the subject matter of which is incorporated herein by reference. The device can be attached to a utility meter and uses cameras to take images of the display of the utility meter.

According to the invention, there is provided a device for detecting opening of a access cover to a pit in which a water utility meter is housed, the device being arranged to be attached to a water utility meter, the device including a light sensor to sense ambient light.

In this way, opening of the access cover to a water utility meter chamber can be detected, as opening the access cover will change the amount of ambient light.

The device may include communication means to communicate with a remote location to notify opening of the access cover. In this way, if an access cover is left open, someone can be sent to close it, to remove the risk to public safety. Also, if tampering is suspected, someone can be sent to inspect the water meter.

The device may include means to read the utility meter. Preferably, the meter reading means is arranged to read the utility meter if the access cover is detected to be opened. In this way, if the water meter is tampered with after opening of the access cover, there will be a reading to show what the meter reading was before tampering took place. The device may further be arranged to store a record of the time the access cover was opened.

Preferably, the light sensor has an optical path towards the access cover to the meter chamber. In a particular embodiment, there may be a window in a casing of the device on the optical path from the light sensor towards the access cover. The light sensor may be encased in clear material. This can help to prevent damage, but also presents a wider area through which light can reach the sensor, so it is less likely that the optical path to the sensor will become blocked.

The device may additionally include means for detecting background vibration. This can provide additional confirmation that a access cover has been opened. It is also useful when it is dark, for example in the case of a ground pit at night.

The vibration detecting means may take any suitable form and may comprise a three axis accelerometer.

The device may include means for detection of liquid, such as water. If the device is underwater, then the amount of light reaching the light sensor will be reduced especially if the water is muddy. The moisture detection means may take any suitable form and in one embodiment may comprise two electrically conducting elements arranged to lie in the environment and means for applying a voltage across the elements and determining if a current flows between the elements. The elements may be pins and may be made of metal, such as stainless steel.

The device may include means to make an assessment of whether the access cover has probably been opened. The device may be arranged to monitor for access cover opening at time intervals. By monitoring periodically, changes can be detected for a window of time. The time intervals may for example be every 60 seconds, or more. The time intervals may be every 180 seconds or less. The time intervals may be every 120 seconds or less. Additionally or alternatively, the device may be arranged to assess access cover opening in response to detection above a threshold.

The processing means may be arranged to be woken when the signal from the light sensor exceeds a certain threshold. The processing means may be arranged to take another light sensor reading once awoken. The processing means may be arranged to be woken when the signal from the vibration sensor exceeds a certain threshold. The processing means may be arranged to be woken when the signals from the light and vibration sensors exceed certain thresholds.

Where the device includes water detection means, the threshold for light intensity indicating opening of the access cover may be reduced. This will take account of the light sensor being covered by water, mud or dirty water, for example due to flooding of the chamber, thus obscuring the light sensor and reducing the light intensity reaching the light sensor.

The assessment means preferably takes into account the time of day. Thus, it will take account of whether it is daytime or night-time and adjust the expectation for the intensity of ambient light accordingly.

The assessment means preferably takes into account the historical pattern of use. For example, if the access cover is historically opened once a month on a particular day of the month, because that is how the user reads the meter, then the system can learn that such an event does not or probably does not constitute tampering, and adjust its reporting accordingly.

The ambient light sensor and/or vibration sensor can be pre-set with detection levels that when exceeded will generate a signal to wake the processing element from inactive state. This will reduce quiescent power consumption compared to continuous sensor metric monitoring by the processing element.

The device may comprise a processing means, and a wake manager. The device may further include a communications engine to communicate externally.

The assessment means may use an adaptive dynamic threshold for triggering. Thus, feedback may be used to adjust the threshold on an ongoing basis.

Embodiments of the invention will now be described by way of example and with reference to the accompanying drawings, in which:
Figure 1 is a side elevation in cross section of the device of the embodiment on a utility water meter in a ground pit with an access cover;
Figure 2 is a plan view of the device of the embodiment on a utility meter
Figure 3 is a perspective view from above of the device of the embodiment;

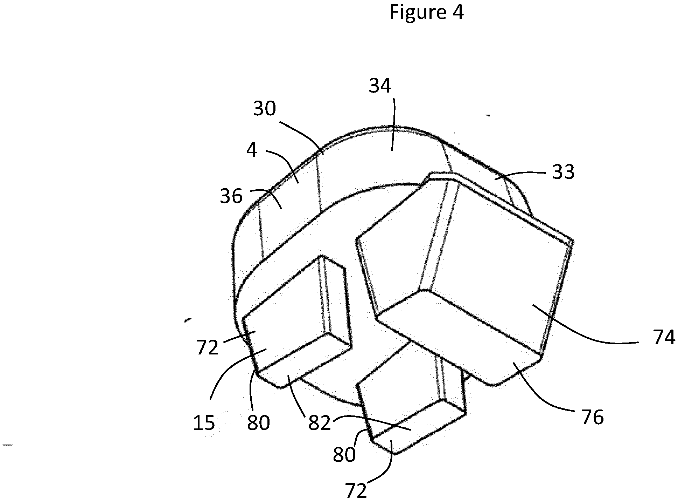

Figure 4 is an underneath perspective view of the device of the embodiment;

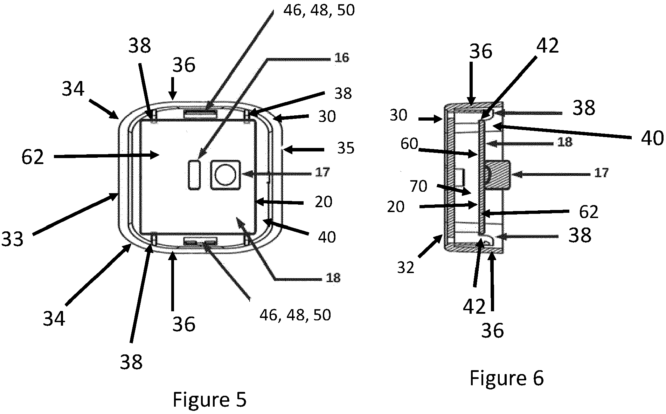

Figure 5 is an underneath plan view of the casing and PCB of the embodiment;
Figure 6 is a side elevation in cross section of the casing and PCB of the embodiment, not showing the batteries;
Figure 7 is an underneath plan view of a PCB of the device of the embodiment;
Figure 8 is a side elevation of the PCB of Fig 7;
Figure 9 is a top plan view of the PCB of Fig 7, not showing the batteries;
Figure 10 is a top plan view of the PCB of Fig 7 showing the batteries;
Figure 11 is a system block diagram of the device of the embodiment; and,
Figure 12 is an algorithm flow diagram of the device of the embodiment.

The device 4 of the embodiment of the invention comprises a prism 15 in a casing 30, and a PCB 20.

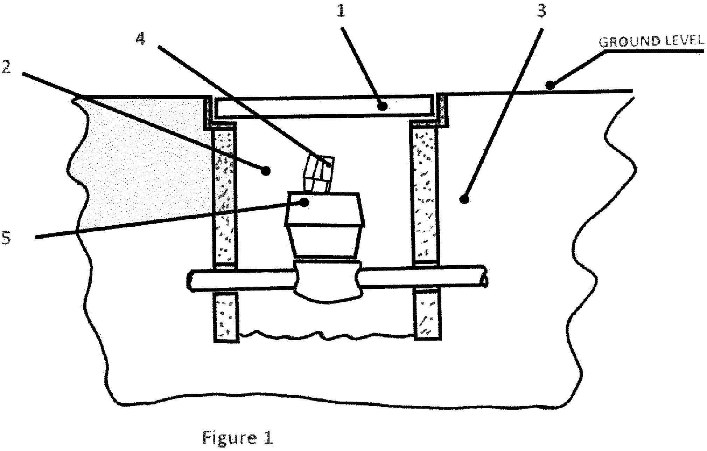

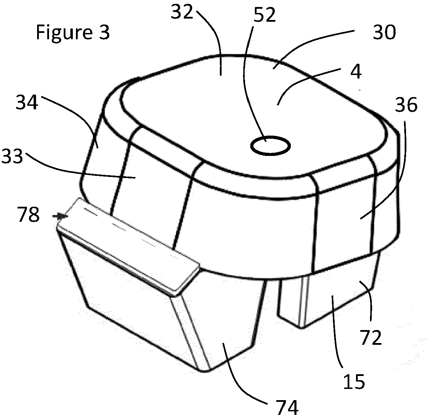

The casing 30 may be injection moulded from opaque plastics material. As shown in figures 1 to 3 , the casing 30 is generally in the form of an upturned rectangular cup with a flat top 32, sides 33, 35, 36, and rounded corners 34. Two opposite sides 36 of the casing carry two spaced ribs 38 extending into the cavity 40 of the casing 30. The ribs 38 on each side face each other. Each rib 38 includes a step 42. Between the two ribs 38 on each of the two sides 36 is provided a clip 46. Each clip 46 depends from the top 32 adjacent one of the said opposite sides 36. Each clip 46 is in the form of a tab 48 and includes an inwardly extending undercut barb 50 near the lower end thereof. The casing 30 has a window 52 in the top 32 adjacent one of the corners.

To construct the device 4, the PCB 20 is clipped into the casing 30. To do this, the PCB is offered up to the casing 30 and pushed into the cavity 40 so that the upwardly facing side 60 of the PCB 20 comes to rest on the steps 42 of the ribs 38. In so doing, the clips 46 will be forced apart by the PCB 20 as it travels into the cavity 40, the clips 46 bending resiliently towards the sides 36. Once the barbs 50 pass the downwardly facing side 62 of the PCB 20, the clips 46 will snap behind the PCB 20 to hold it in place in the casing 30.

The prism 15 is then injection moulded. So the casing 30 with the PCB 20 clipped into it is placed in an injection moulding machine. Clear plastics material is then injection moulded to form the prism 15. The plastics material will flow around the PCB 20 to fill the gap 70 in the cavity 40 behind the PCB 20 and will fully encapsulate the PCB 20. The mould (not shown) is shaped to form three depending feet 72, 74. There is one large foot 74 at the front side 33 of the casing 30. The foot 74 extends over most of the width of the side 33, and presents a substantially rectangular lower surface 76. The foot 74 also extends out beyond the side 33 of the casing 30 to form an upwardly facing ledge 78 along its full width adjacent the lower edge of the side 33. The other two feet 72 are generally rectangular and lie side by side behind the large foot 74. The rear sides 80 of the rear feet 72 depend from adjacent the rear side 35 of the casing 30. The rear feet 72 have an axis extending towards the large foot 74. The lower surfaces 82 of the rear feet 72 are in a common plane with the lower surface 76 of the large foot 74.

The prism 15 may be made from an optically clear casting resin such as Crystalcast 1000 (trade mark).

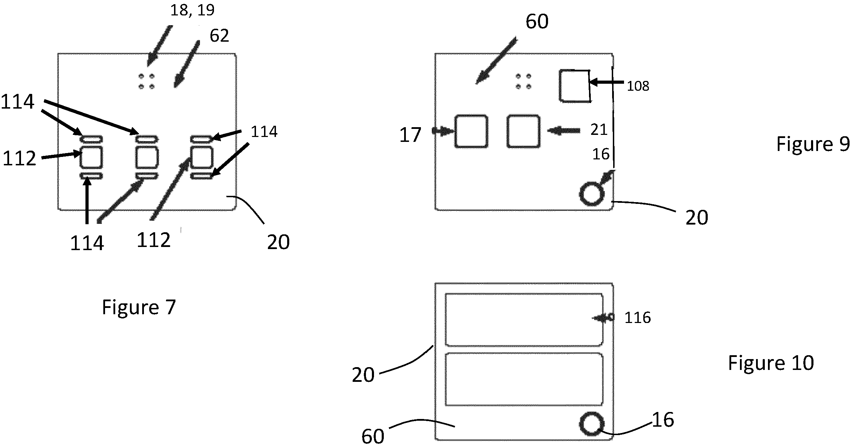

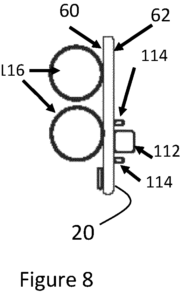

Figures 7 to 10 show the PCB 20. On its upper surface 60, the PCB 20 carries an ambient light sensor 16, a local processing element or CPU 17, a wireless communications element 18, a wired communications interface 19, and a vibration detecting element 21 and a power conditioning subcircuit 108. The lower side 62 of the PCB 20 includes three cameras 112, and two infra red LEDs 114 associated with each camera 112. The cameras 112 are arranged side by side in a row and are directed down through the large foot 74 of the prism 15. A processor 17 is associated with the cameras and receives images from them, which are transmitted back to a remote centre over the wired or wireless connection 18, 19. Two batteries 116 are carried by the PCB 20 on the upper surface 60.

The light sensor 16 may be a VEML6030: a micro power, high accuracy ambient light digital 16-bit resolution sensor in a miniature transparent 2 mm x 2 mm package. The VEML6030 offers a spectral sensitivity in the range 350-800nm, i.e. the visible light range and has the capacity to interrupt (or wake) the processing element 17 or an external processor when ambient light levels exceed a predefined threshold (determined in this application by the adaptive algorithm running on the processing element 17).

A suitable device for the vibration detecting element 21 is an LIS3DSH: a digital output motion sensor, ultra-low-power high-performance three-axis "nano" accelerometer providing 16-bit data resolution on sensitivity ranges from +-2g to +-16g. This device, as in the case of the ambient light sensor, has the capability to interrupt (wake) the processing element 17 or an external processor when a threshold has been exceeded. This threshold will be dynamically set by the adaptive algorithm running in the processing element 17.

The device implementation is specifically optimised for long term operation with a battery. This requires special consideration for the electronic component design and selection as well as a more considered approach with the detection algorithm design. The ambient light sensor 16 and vibration sensor 21 can be pre-set with detection levels that when exceeded will generate a signal to wake the processing element 17 from inactive state, this will reduce quiescent power consumption compared to continuous sensor metric monitoring by the processing element 17. For application when an external power source is available, a wired interface can be used to eliminate a finite operating lifetime compared to the battery product. Important to achieving a low powered design is the ability for the processing element 17 to enter an ultra-low power sleep mode whilst retaining the ability to wake according to internal timers. To achieve this, a variant of the ARM CORTEX can be used, a processing core commonly available from multiple silicon vendors.

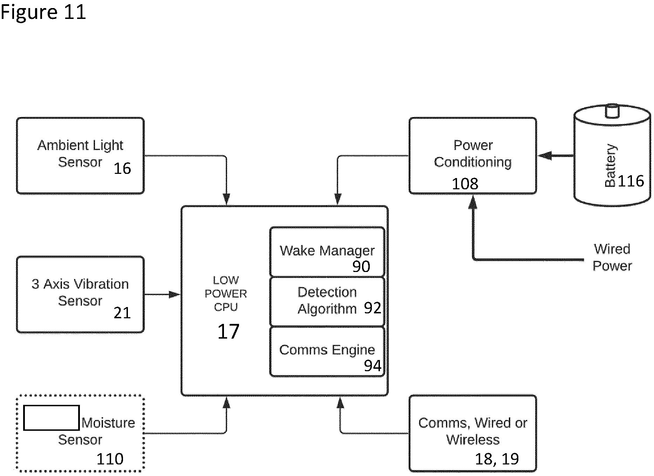

Figure 11 shows further detail of the features which operate the detection algorithm that is implemented locally on the processing element 17 and operates on the measured sensor information within the limitations of a low power system. Thus, the processing element 17 is a low power CPU which includes a wake manager 90, a detection algorithm 92 and a comms engine 94. Base algorithm configuration parameters are loaded by the processing element 17, but can be adjusted remotely using one of the communications links 18, 19. The base operational parameters relate to the nature of the system the device is monitoring. The processing element 17 is in a low power sleep mode for most of its time to reduce quiescent power consumption.

In use, a utility water meter 5 will be located in a ground pit 2.

A pit 2 in the ground 3 creates a chamber in the ground closed by an access cover 1. A water utility meter 5 is found on a pipe at the bottom of the pit 2.

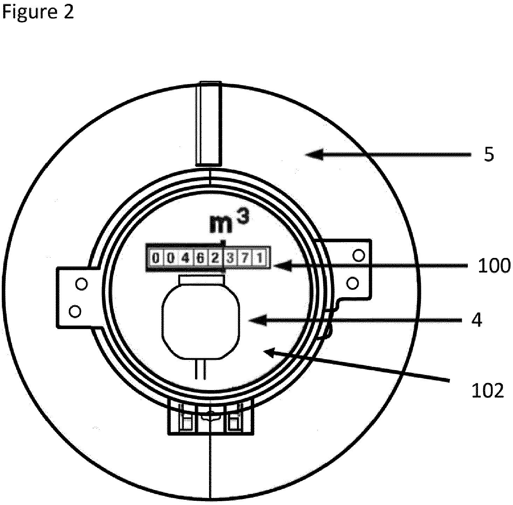

The utility meter 5, has a register display 100 consisting of a row or string of numbers. This may be an LCD or LED display, or a mechanical display, such as a serial arrangement of adjacent rings which turn to display different numbers on their outer periphery, as shown in Fig 2. The device 4 of the invention can be mounted on the utility meter 5. The register display 100 will be behind a transparent cover 102 in the form of a layer of glass or transparent plastic. As shown, the device 4 is mounted offset from the register display 100. This means that the register display 100 can still be read by a user looking at the display 100. To attach the device 4, the surface of the transparent cover 102 adjacent the register display 100 is first cleaned to remove any dirt or grease. A UV curable adhesive, such as LOCTITE AA 3491 (trade mark), is then applied to the lower surface 76 of the large foot 74, and the device 10 is placed on the transparent cover 102. The position of the device 4 is then adjusted, so that the cameras are aligned with the register display 100. The UV adhesive is then cured by shining UV light through the ledge 78 down to the lower surface 76 of the large foot 74.

In operation, three events can wake the processing element 17 from its low power dormant state as follows:
Sensor interrupt by threshold violation of measured metric (ambient light/vibration).
Timer to take sensor readings and maintain an adaptive baseline during normal operation.
Communication subsystem indicating inbound communications request.

Upon wakeup the processing element 17 will determine the cause and take appropriate action. If the wake is a standard timer wakeup, then the sensor values are read, and a software digital filter applied to create adaptive dynamic threshold. If required, the new thresholds will be updated in the sensor devices 16, 21 themselves to support autonomous interrupt generation to wake the processor 17 on threshold violation. This methodology supports a larger time between processor 17 timed wakes maximising power consumption whilst preventing missed events. The wake period will be in the region of 60-120s, possible due to the inherent slowly changing physical quantity that need to be measured.

If the wake reason is identified as autonomous sensor threshold violation (interrupts), the sensors 16, 21 are read to re-confirm the absolute levels and the threshold violation. The decision matrix shown in the table below is used to identify if the violation is a meter access event that needs to be logged and communicated to remote devices.

**Table: Basic decision matrix**

| **Event** | **Outcome** |
|---|---|
| Ambient light violation. New sensor read confirms, no vibration threshold exceeded. | Log as likely meter access |
| Ambient light violation. New sensor read does not agree, no vibration threshold exceeded. | No meter access return to sleep |
| Ambient light violation. New sensor read confirms, vibration threshold exceeded. | Log as meter access |
| Ambient light violation. New sensor read does not agree, vibration threshold exceeded. | Log as likely meter access |
| Vibration violation. New senor read confirms, no ambient threshold violation. | Log as likely meter access |

The base level parameters, including the decision matrix rules will be configurable remotely using the communications link.

Communication of detected meter access event will be using the wired connection 19 or alternatively an integrated wireless radio module 18. The detection event data will be timestamped and provided in a polled manner to the remote device or automatically via an unsolicited communication depending on system integration. The link will also be used to remotely configure the device 4 to support optimisation of base parameters and the decision matrix for the wide range of retro fit meter requirements.

RF technologies suitable for the wireless link are Bluetooth 4/5 for local connection to monitoring station, GSM, NBiOT and CATM1 for direct to mobile network operators' infrastructure and LoRa (or alternative) operating at 433, 868 or 915 MHz in the licence free bands for direct to custom provided base stations and infrastructure. Wired links are based around serial communications over physical layers providing single ended (RS232) or differential pair (RS485) or similar industrial standards.

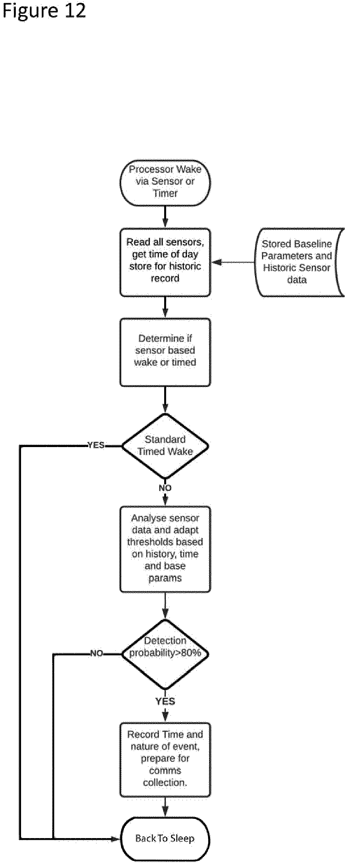

The system operates in accordance with the decision matrix shown in Figure 12. Thus, the processor 17 will wake either through a sensor threshold being exceeded or because a regular time interval has been reached. The processor 17 will read the ambient light sensor 16 and the vibration sensor 21, read the time, and store the sensor readings and time stamp for the historic record. The processor 17 stores this historic record together with baseline parameters. The processor 17 then determines if the waking event was due to one or both sensor thresholds being exceeded or due to a time interval being reached. If the waking event was due to a time interval, provided the sensor readings were not over threshold, there is nothing more to do and the processor 17 goes back to sleep. If the waking event was due to a sensor threshold being exceeded, the processor 17 will analyse the sensor data and adapt the thresholds for the next time period based on the history, time and base parameters. The processor will then assess the probability of detection of opening of the access cover using the table above. If the probability is that the access cover has been opened, then the processor 17 will record the time and nature of the event, and prepare for comms collection. The information can be collected on a regular schedule by the remote centre. Alternatively, the processor 17 can send the information on discovering an unscheduled opening of the access cover.

In this way, if an access cover 1 to a ground pit meter 5 is opened unexpectedly or left open, someone can be sent to close it so it does not represent a hazard to the public. Also, if an access cover 1 to a utility meter 5is opened unexpectedly, a record can be taken, so that tampering can be detected.

The window 52 in the casing 30 provides a direct optical path for ambient light from the access cover to the light sensor 16. The fact that the prism 15 of clear material encapsulates the PCB 20 and hence the light sensor 16, provides further light paths through to the light sensor 16. This approach reduces the risk of small area contamination preventing optical efficiency. Encapsulation of the PCB 20 in the prism 15 material provides a completely waterproof solution.

The device 4 thus can be retro fitted to the surface of a utility meter 5 and provide an accurate timestamp relating to the access of the meter pit 2 (figure 1). This information can be used by a remote monitoring station to identify unauthorised access and risk to the public. Access detection is achieved by identifying an increase in the ambient light level, typical with opening the meter pit 2. A secondary sensor 21 detects the vibration that is often associated with physical access and provides an increased level of confidence. Detection of ambient light is not robust during periods of extreme low light levels (night-time and environment contamination) however, providing time of day and moisture levels as additional information to the detection algorithm, robust detection will be achieved.

As an alternative to UV curable adhesive, a two component epoxy clear adhesive could be used, such as Loctite EA 9455 (trade mark). As a further alternative, an optically clear double sided adhesive tape could be used.

A sensor 110 measuring moisture can be provided.. If the pit 2 is flooded then the optical reading accuracy is potentially reduced, due to contaminants in the water preventing ambient light reaching the light sensor 16. This metric can therefore be used to qualify the detection status. The moisture/water information will be provided by utilising a dedicated sensor 110 that communicates wirelessly or by wire, to the processing element 17. The returned metric will be an index that represents the moisture at the point of contact of two, typically stainless-steel, pins exposed to the environment. Figure 11 shows the incorporation of the moisture sensor 110 in dotted lines.

In the embodiment, an assessment of whether unauthorised opening of an access cover has taken place is made by the device. In an alternative embodiment, signals from the light sensor 16 and vibration sensor 21 and moisture sensor, if provided, can be communicated to an external station for the assessment to take place.

As an alternative to injection moulding, casting may be used, in particular, vacuum casting.

In another embodiment, the LEDs 114 alongside the cameras 112 may not be infra red but may be another wavelength of optical radiation, or may be multispectral.

In another embodiment, there may be only one battery 116.

## Claims

1. A device for detecting opening of an access cover to a pit in which a water utility meter is housed, the device being arranged to be attached to a water utility meter, the device including a light sensor to sense ambient light.

2. A device as claimed in claim 1, wherein the device includes communication means to communicate with a remote location.

3. A device as claimed in claim 1 or claim 2, wherein the device includes means to read the utility meter, and optionally wherein the meter reading means is arranged to read the utility meter if the access cover is detected to be opened.

4. A device as claimed in any preceding claim, wherein the device is arranged to store a record of the time the access cover was opened.

5. A device as claimed in any preceding claim, wherein the light sensor has an optical path towards the access cover to the meter chamber, and optionally wherein a window is provided in a casing of the device on the optical path from the light sensor towards the access cover.

6. A device as claimed in any preceding claim, wherein the light sensor is encased in clear material.

7. A device as claimed in claim 6, wherein the light sensor is encased in a block of clear material, and the device includes a casing which covers at least one side but not all sides of the block of clear material.

8. A device as claimed in claim 6 or claim 7, wherein the block of clear material includes at least one foot to engage a utility meter.

9. A device as claimed in any preceding claim, wherein the device includes means for detecting background vibration, optionally wherein the vibration detecting means comprises a three axis accelerometer.

10. A device as claimed in any preceding claim, wherein the device includes means for detection of water.

11. A device as claimed in claim 13, wherein the water detection means comprises two electrically conducting elements arranged to lie in the environment and means for applying a voltage across the elements and determining if a current flows between the elements and optionally wherein the elements are pins, and optionally wherein the elements are made of stainless steel.

12. A device as claimed in any preceding claim, wherein the device includes means to make an assessment of whether the access cover has probably been opened.

13. A device as claimed in claim 12, wherein the device is arranged to monitor for access cover opening at time intervals, and optionally wherein the time intervals are every 60 seconds, or more, and optionally wherein the time intervals are every 180 seconds or less, and optionally wherein the time intervals are every 120 seconds or less.

14. A device as claimed in claim 12 or claim 13, wherein the device is arranged to assess access cover opening in response to detection above a threshold.

15. A device as claimed in claim 14 wherein the device includes processing means, and the processing means is arranged to be woken when the signal from the light sensor exceeds a certain threshold, and optionally wherein the processing means is arranged to take another light sensor reading once awoken.

16. A device as claimed in claim 15, wherein, where the device includes water detection means, the threshold for light intensity indicating opening of the access cover is reduced if water is detected.

17. A device as claimed in claim 14, 15 or 16 and where the device includes means for detecting background vibration, wherein the device includes processing means, and the processing means is arranged to be woken when the signal from the vibration sensor exceeds a certain threshold.

18. A device as claimed in any of claims 12 to 17, wherein the assessment means takes into account the time of day, and optionally wherein the assessment means takes into account the historical pattern of use, and/or optionally wherein the assessment means uses an adaptive dynamic threshold for triggering.
